Europäisches Patentamt

European Patent Office

Office européen des brevets

(19)

(11) **EP 0 735 693 A1**

(12) **EUROPEAN PATENT APPLICATION**

(43) Date of publication:
**02.10.1996 Bulletin 1996/40**

(51) Int Cl.⁶: **H03L 7/189**

(21) Application number: **96302108.4**

(22) Date of filing: **27.03.1996**

(84) Designated Contracting States:
**AT DE FR GB SE**

(30) Priority: **28.03.1995 FI 951471**

(71) Applicant: **NOKIA MOBILE PHONES LTD.**
**24101 Salo (FI)**

(72) Inventor: **Kukkonen, Osmo**
**24100 Salo (FI)**

(74) Representative: **Haws, Helen Louise**
**Nokia Mobile Phones,**
**Patent Department,**
**St. Georges Court/St. Georges Road,**
**9 High Street**
**Camberley, Surrey GU15 3QZ (GB)**

(54) **A voltage controlled oscillator circuit**

(57) The invention relates to a method for tuning the frequency, particularly the medium frequency, of a voltage controlled oscillator (VCO). The medium frequency of a VCO is tuned by controlling the voltage by means of a microprocessor (2), an analog/digital converter (7) and a digital/analog converter (6). By using the invention, it is also possible to compensate for frequency drift of the VCO circuit due to the temperature without having to measure the temperature separately. The method is applied favourably in different types of mobile telephones.

Fig. 2

## Description

This invention relates to a circuit and method for controlling the output frequency of a voltage controlled oscillator, and particularly but not exclusively for use in radio telephones.

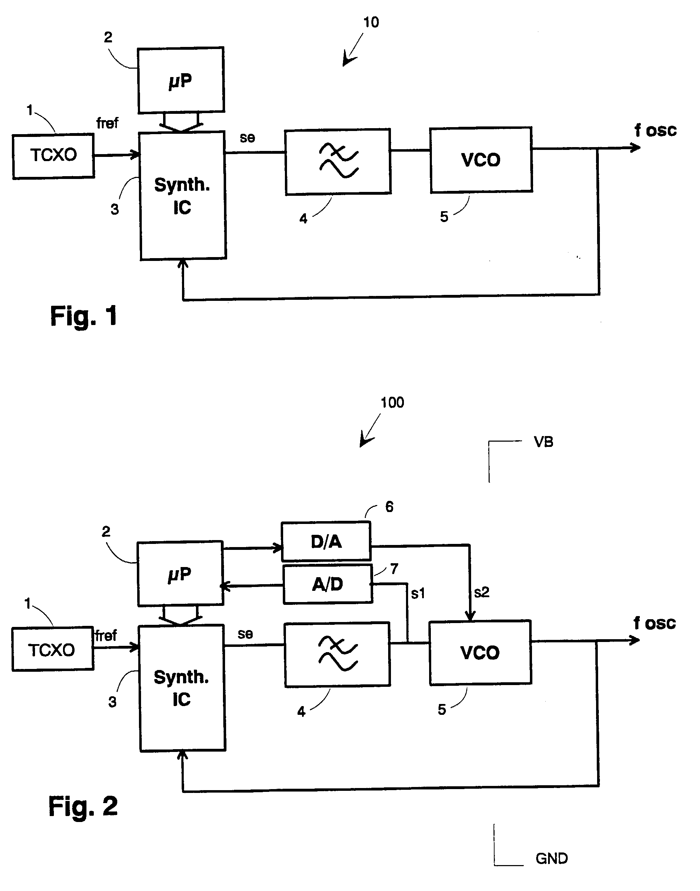

In generating frequency signals in radio telephones sometimes termed mobile telephones, frequency synthesizing in a phase-locked loop is used at present. These frequency signals are, for example, the frequencies of the local oscillator of the receiver and the transmitter signal. Fig. 1 shows a typical block diagram of a frequency synthesizer 10 of a mobile telephone as an example. In the block diagram, an integrated synthesizer circuit (Synth. IC) which is marked with the reference number 3 includes necessary dividers and a phase comparator to allow respective output frequencies to be realised.

A temperature compensated crystal-driven oscillator 1 (TCXO) operates as a reference oscillator producing a reference frequency fref to which an output of a frequency synthesizer, defined as the frequency signal fosc, is locked. A microprocessor 2 ($\mu$P) which in this case is also controlling other functions of a mobile telephone, is responsible for generating respective dividing numbers for a desired radio telephone channel, and the microprocessor feeds the dividing numbers along a data bus to an IC-circuit 3. A synthesizer circuit, which is a comparison circuit, compares the output frequency fosc divided by the first dividing number with the reference frequency $f_{ref}$ divided by the second dividing number and generates a control signal se as a result of the comparison. The output of the synthesizer circuit 3, that is the control signal se, is conducted via a low pass filter 4 to a voltage controlled oscillator 5 (VCO). The output signal of this oscillator constitutes at the same time the output frequency $f_{osc}$ of the frequency synthesizer circuit. The output frequency is also transferred to the IC-circuit 3 as a feedback signal as shown in Fig. 1.

When fosc $\neq$ TCXO or $\frac{fosc}{N_2} \neq \frac{TCXO}{N_1}$ ie the oscillation frequency output from the phase locked loop is not the desired frequency, the phase difference between fosc and the desired frequency ($\frac{TCXO}{N_1}$) will vary with time (Se (t)).

The filtered signal S'e(t) having passed through the filter 4 forces the VCO to change frequency in the direction that reduces the difference between the desired frequency and the divider output frequency. As the two frequencies are typically arranged to be close, S'e(t) forces the two frequencies to become equal at which point the signal S'e(t) tends to a constant voltage level representative of a constant phase difference between the output and input signals. The constant voltage is at the level required to drive the VCO at the desired frequency.

The self correcting ability of the phase locked loop (PLL) allows it to track frequency changes in the VCO output that result from, for example, component operating parameters that vary with temperature. The range of frequencies over which the PLL can remain locked to an input signal is know as its 'lock range'. It's 'capture range' which is smaller than the lock range is the range of frequencies over which the loop can achieve a lock to a particular frequency.

In a voltage controlled oscillator circuit 5 of the type shown in Fig. 1, usually some kind of method for tuning the medium frequency must be used to eliminate the effect of component tolerances in allowing the lock and capture ranges to differ from those required for the VCO. Mechanical means such as trimmer capacitors and modifying the mechanical dimensions of the resonator are known as well as electrical means, for example, involving tuning methods based on using capacitance or p-i-n diodes. In cases like these, the tuning must be accomplished either by the component manufacturer, for example, by using VCO module manufacturer. When an electrical device, for example a mobile telephone, is equipped with a VCO which is made in telephone production from discrete components, tuning is best accomplished during the final test procedure. Mechanical tuning is known to be awkward and time consuming.

One electrical tuning method is known, for example, from US-patent 4,810,974. In it, an analog/digital converter is used to correct for drift in a VCO circuit. However, this patent does not deal with tuning the medium or mid frequency of the VCO. In addition, in the above mentioned US-patent, a feedback loop is not closed in actual terms but the frequency is corrected and compensated periodically by feedback assessment of data.

In accordance with the present invention there is provided a circuit for controlling the output frequency of a voltage controlled oscillator, comprising means for providing a reference frequency; means for comparing the output of a voltage controlled oscillator with the output of the means for providing a reference frequency and providing a first control signal indicative of a difference therebetween; a processor operable to provide a second control signal; and means for combining the first and second control signals to provide a combined control signal, the output frequency of the voltage controlled oscillator being responsive to the combined control signal; the processor being operable to control the value of the second control signal for regulating the value of the first control signal.

Other favourable embodiments have been presented in non-independent patent claims.

By providing a combined control signal to the voltage controlled oscillator, the value or level of the first control signal can be regulated by the level of the second control signal. This allows the absolute voltage level of the first control signal to be maintained within predetermined limits. The predetermined limits can be chosen to coincide with the maximum and minimum dc voltages suppliable to the circuit.

The circuit is preferably adaptable to allow respective output frequencies to be provided. This allows the circuit to be used in, for example, a radio telephone that operates at respective transmit and receive frequencies. It is also utilisable for a radio telephone operable at respective transmit frequencies and respective receive frequencies.

One problem with circuits for controlling the output frequency of a voltage controlled oscillator is that in a feed back circuit, the range of values necessary for the control signal to capture a predetermined voltage controlled oscillator output frequency is greater than that required to maintain the voltage controlled oscillator at a particular frequency once lock has been achieved. The range of voltage levels required to capture the voltage controlled oscillator at a particular output frequency is termed a tuning 'window' or the 'capture range' of the voltage controlled oscillator. The second control signal of the present invention is arranged to ensure the combined control signal is capable of adopting the range of absolute values necessary to capture the range of output frequencies the circuit may need to adopt under the conditions, eg temperature, likely to be encountered.

By providing a second control signal, the first control signal is able to carry time dependent information on the phase difference between the of the PLL frequency and the desired reference signal as a result of the difference in frequency of the two signals for locking the voltage controlled oscillator to the desired reference frequency. The second control signal is able to provide a dc voltage level for maintaining the absolute value of the first control signal between reproducable levels.

The second control signal is preferably provided such that the first control signal is maintained substantially in the middle of its allowable limits for a output frequency that falls towards the mid range of frequencies to be supplied by the circuit.

The second control signal may be responsive to the desired frequency of operation of the voltage controlled oscillator as well as the level of the first control signal. This allows the range of values of the frist control signal to be regulated for each output frequency. It may, under some circumstances, be desirable to maintain the first control signal substantially in the middle of its allowable range for each desired output frequency of the circuit. Otherwise, for each output frequency, the allowable range of values for the first control signal could be regulated to ensure it does not need to exceed its limits for capture for the desired output frequencies at the extremes of operation.

In accordance with a second aspect of the invention there is provided a method for controlling the frequency of a voltage controlled oscillator (5) in a phase-locked loop in which a comparison circuit (3) is fed a reference frequency (fref) and an output frequency (fosc) of the voltage controlled oscillator (5) and dividing numbers from the control circuit (2) at which the comparison circuit (3) compares the output frequency divided by the first dividing number to the reference frequency divided by the second dividing number and as a result of the comparison forms a control signal (se) which through filtering (4) controls the voltage controlled oscillator (5) to form a desired output frequency (fosc), characterised in that dividing numbers corresponding to a desired output frequency (fosc) are fed to a comparison circuit (3), the value of the control voltage (s1) is measured to which proportional correction data is recorded into the memory of a control circuit (2), from the memory, the correction data is read to which a proportional correction signal (s2) is used for controlling a voltage controlled oscillator (5) in such a way that the control signal (se) settles essentially at a constant value.

The output frequency of a voltage controlled oscillator is controlled in accordance with one embodiment of the invention in such a way that dividing numbers corresponding to the desired output frequency are fed to a comparison circuit. The value of the control voltage is measured and proportional correction data is recorded into the memory of the control circuit. The correction data is then read from the memory, and a correction signal proportional to the correction data is used for controlling the voltage controlled oscillator in such a way that the control signal tends to settle essentially at a desired constant value. This desired constant value is preferably in the middle of the control range of the control signal. In a preferred embodiment, the method is used for tuning the medium frequency of a voltage controlled oscillator and can be carried out during oscillator manufacturing or preferably during final oscillator testing.

Embodiments of the invention can also be used, in addition to tuning the medium frequency, to compensate for the variation in component values caused by a temperature change. The variation in component values is detected by a change in the voltage rating of the control signal. In this case, a second correction data is transferred into the memory of the control circuit, favourably only if its absolute value exceeds the predetermined threshold value. Thereafter, a sum of the first correction data and the second correction data is generated in the control circuit, and a correction signal proportional to this sum is used for controlling the voltage controlled oscillator. In this way, both the medium frequency and compensation for temperature can be dealt with by using the same circuit arrangement. In this case, one does not need to measure the actual value of temperature and there is no need to use temperature dependent components to cancel temperature drift.

Embodiments of the invention are favourably applied to a radio or mobile telephone.

In accordance with the invention, the medium frequency of the VCO is tuned by controlling the voltage by means of a microprocessor, an analog/digital converter and a digital/analog converter. Information concerning the value of the control voltage of a phase-locked loop is conducted via an analog/digital converter to the microprocessor responsible for tuning the medium frequency. In this way, it is possible to achieve a completely automatic and programmable tuning which is controlled by a program which can be included in the memory of the microprocessor controlling the device, for example, a mobile telephone. A further advantage is the fact that microprocessor circuits in present-day mobile telephones already include analog/digital and digital/analog converters which can be utilized in the invention.

Embodiments of the invention can be applied, in addition to the tuning of the medium frequency, for other compensations as well, for example, in compensating for frequency drift of the VCO caused by a temperature change, as was mentioned earlier. As a favourable additional feature of the invention, a significant saving in power use of a mobile telephone is gained since the value of control voltage of the VCO control can be kept near constant independent of the selected channel. In this case, the necessary voltage range can be minimized and thus the number of battery cells which are the power source of the device can be minimized.

The invention is explained in the following by referring to the attached Fig. 2 which shows an embodiment of the invention applied to an oscillator circuit of a mobile telephone.

Compared with the oscillator circuit 10 shown in Fig. 1, in the circuit 100 in Fig. 2 a connection has been formed from the output of a low pass filter 4 to a microprocessor 2 via an analog/digital converter 7. In addition, a VCO 5 is controlled by the microprocessor 2 via a digital/analog converter 6. The control voltage range which is available for the oscillator circuit 100 is determined by the value of the supply voltage VB in use. The connection of the supply voltage VB and the ground potential GND of the circuit has only been presented in the illustration, since it has been realized in a way which is familiar to a person skilled in the art. If, for example, the value of the supply voltage VB which is conducted to a synthesizer circuit 3 is 4.5 V, the range of the control voltage available to the synthesizer circuit could be between 1.0 ... 3.3 V in which case the lower limit 1.0 V corresponds to the lower channel of a mobile telephone and the upper limit 3.3 V to the upper channel. A certain tolerance, in this case 1 ... 1.2 V must be left between the supply voltage VB and the upper limit and, on the other hand, between the ground potential and the lower limit to permit for either excess voltage occurring in control voltage or undervoltage in a fast control situation while still being able to take precautions against possible temperature drift. With the voltage values presented herein it would be sensible to set 2.15 V as a voltage value of the medium channel. When a small tolerance is allowed to the target value of the control voltage of the medium channel, one could permit it to vary between tolerance limits 2.1 ... 2.2 V. In tuning the medium frequency, the synthesizer would be set to the medium channel and by reading from the analog/digital converter 7, the voltage value s1 at the output of the low pass filter 4 would be compared to the target value at the microprocessor 2 after which the microprocessor would generate an output signal s2 via a digital/analog converter 6 for controlling the output frequency fosc of the voltage controlled oscillator 5.

In addition to the previously mentioned tuning of the medium frequency, the arrangement according to the invention shown in Fig. 2 can be applied in compensating for variation in output frequency of an oscillator caused by a temperature change. In the usual cases, a phase-locked loop 5-3-4-5 itself corrects for small temperature changes but this will result in a change in the control voltage value. For example, in the lower channel and higher channel of the frequency band the change in control voltage value se may be excessive which means it exceeds the normal operating limits. The circuit in accordance with the invention can be utilized to prevent this as will be explained in the following.

The changed output frequency fosc controls the synthesizer 3 and its output voltage se which is filtered (4) and conducted via an analog/digital converter 7 to a microprocessor 2. The microprocessor, after reading the changed voltage value which is proportional to the output frequency compares it with its set value and generates a correction, either upwards or downwards, and this correction, added to a control signal, is conducted via a digital/analog converter 6 to an oscillator VCO 5. This feedback loop corrects the output frequency fosc such that it is equivalent to the set value and, at the same time, the control voltage of the oscillator is corrected within normal limits. It should be noted that one does not need at any stage to send the actual temperature value to the control circuit but the relevant control data is obtained from the change in the control voltage of the oscillator indicated on the analog/digital converter 7.

Temperature change affects the frequency of oscillation. When the phase difference is locked, the output frequency of the circuit keeps constant but the controlling DC-voltage signal s1 changes to correct for temperature drift in the frequency of the VCO. This change in s1 can be a problem in low battery voltage equipment when only a limited voltage range is available. So the μP reads signal s1 periodically and if the A/D converted signal drifts outside a predetermined window for a specific output frequency, the μP can return that signal level back to preferred range by varying signal s2 which provides an additional DC-voltage for controlling the frequency of oscillation of the VCO. The analog dc voltage is formed with the aid of the D/A-converter 6. Once the μP 2 has determined that s1 has drifted outside its desired operation window based on A/D-converted value from A/D 7, s2 is changed in a sequential manner by μP 2 using small steps which are translated to voltage values by D/A 6 until s1 has adopted its preferred value. Other compensation techniques could be employed to vary s2 to ensure s1 is maintained within a desired window. This window could be related to the output frequency or could be substantially contstant irrespective of the output frequency to further reduce the required voltage range for se.

As was mentioned in the general part, aim in radio telephones is to minimize the number of cells in batteries used in portable mobile telephones and thus reduce the weight and size of the device. This leads to a reduction in the supply voltage. Since saving power is also one of the main objectives in mobile telephone business, the aim is to have a so-called stacking connection where circuits share the current but the supply voltage available for each separate circuit will be reduced. In the circuit shown in Fig. 2, the circuits could be stacked in which case, for example, the synthesizer IC must operate on a very low supply voltage. This is, however, possible with the help of the invention since VCO control which is equipped with a digital/analog converter and thus can maintain the control voltage of the VCO that is the voltage of the synthesizer circuit 3 filtered through the low pass filter 4 so that it is almost constant independent of which channel is selected for use in the mobile telephone. In this case, the control voltage is measured by an analog/digital converter 7 and the correction needed for the control voltage is conducted via a digital/analog converter 6 to an oscillator 5 as was previously explained, in which case the control voltage need not be changed even though the channel is changed. Thus also the voltage range needed for the phase comparator included in the synthesizer IC 3 and also for the whole synthesizer IC can be minimized so that the voltage range nonetheless covers the voltage range needed to maintain the phase lock.

The present invention includes any novel feature or combination of features disclosed herein either explicitly or any generalisation thereof irrespective of whether or not it relates to the claimed invention or mitigates any or all of the problems addressed.

In view of the foregoing description it will be evident to a person skilled in the art that various modifications may be made within the scope of the invention.

## Claims

1. A circuit for controlling the output frequency of a voltage controlled oscillator, comprising:

   means for providing a reference frequency;
   means for comparing the output of a voltage controlled oscillator with the output of the means for providing a reference frequency and providing a first control signal indicative of a difference therebetween;
   a processor operable to provide a second control signal; and
   means for combining the first and second control signals to provide a combined control signal, the output frequency of the voltage controlled oscillator being responsive to the combined control signal;
   the processor being operable to control the value of the second control signal for regulating the value of the first control signal.

2. A circuit according to claim 1 wherein the circuit comprises means for allowing the first control signal to adopt a range of voltage values between upper and lower limits, and wherein the processor is operable to provide a second control signal having a value such that the value of the first control signal falls substantially mid way between the upper and lower limits under predetermined conditions when the output of the voltage controlled oscillator has a predetermined frequency.

3. A circuit according to any preceding claim wherein the voltage controlled oscillator is operable to provide respective predetermined output frequencies and the value of the second control signal is variable such that the value of the first control signal is maintained within respective limits for each of the respective predetermined output frequencies.

4. A circuit according to any preceding claim wherein the value of the first control signal is monitored by the processor and wherein the second control signal provided by the processor is responsive to the value of the first control signal.

5. A circuit according to any preceding claim wherein the processor is operable to determine the output frequency of the circuit and wherein the second control signal comprises a fixed component for compensating for an offset between the desired value of the first control signal for a predetermined output frequency and the actual value thereof under predetermined conditions, and a variable component dependent on the value of the first control signal and the output frequency of the circuit.

6. A circuit according to claim 5 wherein the variable component is determined as a result of a sequential adjustment to the fixed component until the first control signal adopts a predetermined value for each respective predetermined output frequency.

7. A circuit according to any preceding claim wherein the value of the signal is read as an analogue signal which is converted into a digital signal in an analogue to digital converter.

8. A circuit according to any preceding claim wherein the processor provides a digital signal for providing the second control signal which is converted to an analogue signal for combining with the first control signal in a digital to analogue converter.

9. A radio telephone for operation at respective predetermined frequencies comprising a circuit according to any preceding claim.

10. A radio telephone according to claim 9 wherein the radio telephone is digital comprising an analogue to digital converter and a digital to analogue converter and wherein and the analogue to digital conversions of the first control signal and the digital to analogue conversion of the second control signal occur respectively in the analogue to digital and digital to analogue converters of the radio telephone.

11. A method for controlling the frequency of a voltage controlled oscillator (5) in a phase-locked loop in which a comparison circuit (3) is fed a reference frequency (fref) and an output frequency (fosc) of the voltage controlled oscillator (5) and dividing numbers from the control circuit (2) at which the comparison circuit (3) compares the output frequency divided by the first dividing number to the reference frequency divided by the second dividing number and as a result of the comparison forms a control signal (se) which through filtering (4) controls the voltage controlled oscillator (5) to form a desired output frequency (fosc), characterised in that

- dividing numbers corresponding to a desired output frequency (fosc) are fed to a comparison circuit (3),
- the value of the control voltage (s1) is measured to which proportional correction data is recorded into the memory of a control circuit (2),
- from the memory, the correction data is read to which a proportional correction signal (s2) is used for controlling a voltage controlled oscillator (5) in such a way that the control signal (se) settles essentially at a constant value.

12. A mobile telephone according to a patent claim 11, characterised in that in connection with final testing of the manufacturing, correction data corresponding to each channel is recorded into the memory of the control circuit (2) of the mobile telephone so that the correction data (s2) can be extracted from the memory and corresponds to the selected channel and this arranges that the output frequency (fosc) of the voltage controlled oscillator is set so that the control signal (se) stays essentially in the middle of the control range.

13. A method for controlling a circuit for controlling the output frequency of a voltage controlled oscillator, comprising the steps of:

providing a reference frequency;
comparing the output of a voltage controlled oscillator with the reference frequency and providing a first control signal indicative of a difference therebetween;
providing a second control signal; and
combining the first and second control signals to provide a combined control signal, the output frequency of the voltage controlled oscillator being responsive to the combined control signal;
the value of the second control signal being controlled such that the value of the first control signal is regulated.

Fig. 1

Fig. 2

European Patent Office

**EUROPEAN SEARCH REPORT**

Application Number

EP 96 30 2108

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP-A-0 360 442 (NIPPON TELEGRAPH AND TELEPHONE CORP.) <br> * page 6, line 20 - page 7, line 3; figures 7,15 * <br> --- | 1-13 | H03L7/189 |
| X | GB-A-2 242 796 (SAMSUNG ELECTRONICS COMPANY LTD.) <br> * page 3, line 29 - page 7, line 11; figure 2 * <br> --- | 1-13 | |
| X | ELECTRONICS AND COMMUNICATIONS IN JAPAN, vol. 76, no. 9, 1 September 1993, NEW YORK,US, <br> pages 44-54, XP000449116 <br> Y. TARUSAWA ET. AL.: "DIGITAL LOOP PRESET SYNTHESIZER (DLPS) FOR HIGH SPEED FREQUENCY SWITCHING" <br> * page 44, column 1, line 1 - line 12 * <br> * page 45, column 2, line 17 - page 47, column 1, line 7 * <br> * page 51, column 2, line 3 - line 25 * <br> * page 53, column 1, line 23 - column 2, line 3; figure 2 * <br> --- | 1-13 | |
| X | US-A-4 847 569 (T. DUDZIAK ET. AL.) <br> * column 5, line 2 - column 6, line 9; figure 3 * <br> --- | 1-13 | TECHNICAL FIELDS SEARCHED (Int.Cl.6) <br><br> H03L |
| A | US-A-5 182 528 (M. ZUTA) <br> * column 3, line 26 - column 4, line 7; figure 1 * <br> ----- | 1 | |

The present search report has been drawn up for all claims

| Place of search | Date of completion of the search | Examiner |
|---|---|---|
| THE HAGUE | 18 June 1996 | Butler, N |